(19) **Europäisches Patentamt**
**European Patent Office**
**Office européen des brevets**

(11) **EP 1 382 046 B1**

(12) **EUROPÄISCHE PATENTSCHRIFT**

(45) Veröffentlichungstag und Bekanntmachung des Hinweises auf die Patenterteilung:
**02.11.2011 Patentblatt 2011/44**

(21) Anmeldenummer: **02722119.1**

(22) Anmeldetag: **22.02.2002**

(51) Int Cl.:
*H01F 1/00* (2006.01)    *H01L 43/10* (2006.01)

(86) Internationale Anmeldenummer:
**PCT/EP2002/001876**

(87) Internationale Veröffentlichungsnummer:
**WO 2002/069356 (06.09.2002 Gazette 2002/36)**

(54) **VERBINDUNGEN MIT RIESENMAGNETWIDERSTAND UND SPINPOLARISIERTEM TUNNELN, IHRE HERSTELLUNG UND VERWENDUNG**

COMPOUNDS HAVING GIANT MAGNETORESISTANCE AND SPIN-POLARIZED TUNNELS, THE PRODUCTION THEREOF AND THEIR USE

COMPOSES A RESISTANCE MAGNETIQUE GEANTE ET A TUNNELS A SPIN POLARISE, LEUR PRODUCTION ET LEUR UTILISATION

(84) Benannte Vertragsstaaten:
**AT BE CH CY DE DK ES FI FR GB GR IE IT LI LU MC NL PT SE TR**

(30) Priorität: **23.02.2001 DE 10108760**
**22.11.2001 DE 10157172**

(43) Veröffentlichungstag der Anmeldung:
**21.01.2004 Patentblatt 2004/04**

(73) Patentinhaber: **International Business Machines Corporation**
**Armonk, NY 10504 (US)**

(72) Erfinder:
• **FELSER, Claudia**
**55268 Nieder-Olm (DE)**
• **BLOCK, Thomas**
**47058 Duisburg (DE)**

(74) Vertreter: **Döhler, Denis**
**IBM Deutschland Management & Business Support GmbH**
**Patentwesen u. Urheberrecht**
**71137 Ehningen (DE)**

(56) Entgegenhaltungen:
**EP-A- 0 877 398    JP-A- 11 055 058**
**US-A- 6 069 820**

• **E.P. WOLFARTH ET AL: "Ferromagnetic materials Vol 4" 1988 , ELSEVIER , AMSTERDAM NL XP002208732 Seite 540 -Seite 547 Seite 259 -Seite 261**
• **DATABASE INSPEC [Online] INSTITUTE OF ELECTRICAL ENGINEERS, STEVENAGE, GB; NAGANO T ET AL: "Magnetic properties of the Fe/sub 2/MnSi- and Fe/sub 2/VSi-based Heusler alloys" Database accession no. 4914208 XP002208733 & INTERNATIONAL CONFERENCE ON MAGNETISM, ICM '94, WARSAW, POLAND, 22-26 AUG. 1994, Bd. 140-144, pt.1, Seiten 123-124, Journal of Magnetism and Magnetic Materials, Feb. 1995, Netherlands ISSN: 0304-8853**
• **KACZMARSKA K ET AL: "Anderson localization of 3d Mn states in semi-Heusler phases", PHYSICAL REVIEW B, vol. 60, no. 1, 7 January 1999 (1999-01-07), pages 373-382, XP000832302, AMERICAN INSTITUTE OF PHYSICS, NEW YORK [US]**
• **ISHIDA S ET AL: "Search for half-metallic compounds in Co2MnZ (Z=IIIb, IVb, Vb element)", JOURNAL OF THE PHYSICAL SOCIETY OF JAPAN, vol. 64, no. 6, June 1995 (1995-06), pages 2152-2157, XP9096652, JP DOI: 10.1143/JPSJ. 64.2152**

**Beschreibung**

Die vorliegende Erfindung betrifft Verbindungen, die sich für den Einsatz in der Magnetoelektronik eignen. Magnetoelektronik ist eine neuartige Elektronik, welche Magnetwiderstandseffekte und spinpolarisierte Elektronen in elektronischen Bausteinen nutzt bzw. in Zukunft nutzen will. Solche Verbindungen können wegen ihrer magnetoresistiven Eigenschaften unter anderem als Sensoren für Magnetfelder verwendet werden. Unter den magnetoresistiven Eigenschaften wird die Änderung des elektrischen Widerstandes unter Einfluss eines äußeren Magnetfeldes verstanden (Magnetwiderstandseffekt). Weiterhin können solche Verbindungen aufgrund des spinpolarisierten Tunnelns bei Raumtemperatur als Grundbausteine zur Konstruktion von sogenannten *Magnetic Random Access Memories* (MRAM) und von Spintransistoren verwendet werden. Unter spinpolarisiertem Tunneln versteht man das Tunneln (quantenmechanische Überwindung einer Potentialbarnere) von Elektronen, wobei die Tunnelwahrscheinlichkeit von der Spinpolarisation der Elektronen abhängt.

Magnetsensoren werden in den Magnetköpfen von Festplattenlaufwerken verwendet, die z. B. als externe Speichervorrichtungen für Computer eingesetzt werden. Hetkömmliche Magnetköpfe erkennen die Stärke und Richtung eines Magnetfeldes auf der Basis eines Stromes, der in einer Spule induziert wird. Wenn jedoch die Aufzeichnungsdichte zunimmt, nimmt der Aufzeichnungsbereich für ein Bit ab, und die resultierenden Magnetfelder werden progressiv kleiner. Zum Erkennen von solch kleinen externen Magnetfeldern werden hochempfindliche Magnetsensoren benötigt, die mit der herkömmlichen Technologie nicht zu verwirklichen sind. Magnetsensoren, die einen Magnetwiderstandseffekt GMR (giant magnetoresistance)- oder den TMR (tunneling magnetoresistance)-Effekt nutzen, sind als solche Magnetsensoren mit hoher Empfindlichkeit bekannt (S. Mengel, Innovationspotential Magnetoelektronik, Physikalische Blätter, 55(5) 1999, S. 53-56). Magnetsensoren mit Effekten bei Temperaturen um 200 °C finden in der Automobilindustrie Anwendung. Der CMR (colossal magnetoresistance)-Effekt in Verbindungen wie den Manganoxiden erreicht zwar einen um mehrere Größenordnungen größeren Effekt, ist aber wegen der geringen Feldempfindlichkeit noch nicht von technologischem Interesse.

GMR- und TMR-Elemente sind die Grundbausteine zur Konstruktion deutlich verbesserter MRAMs. MRAMs verbinden die Vorteile von Halbleiterspeichern (schnelle Zugriffszeiten) und magnetischen Materialien (hohe Speicherdichte). Außerdem ist der Auslesevorgang nicht destruktiv und die Daten daher nicht flüchtig. Sie sind robust, energieautark und strahlungsresistent.

Die magnetoelektronischen Effekte machen es prinzipiell möglich, magnetisch schaltbare Spintransistoren für ein neuartiges Design elektronischer Schaltungen herzustellen. Dabei kommen sowohl TMR-Elemente als auch Magnet-Halbleiter-Hybride zum Aufbau einer Transistorschaltung in Frage. Die Bauelemente (Spin FET (Field Effect Transistor)) sind einfacher aufgebaut als die üblichen MOSFETs (Metal Oxide Semiconductor Field Effect Transistor) und die beiden Zustände (sperren und durchlassen) sind nicht flüchtig. Eine mehrwertige Logik durch Kombination von magnetischen metallischen Elementen mit Halbleiterelementen kann möglich werden (G. Bayreuther, S. Mengel, Magnetoelektronik, Grundlagenforschung - Zukunftstechnologie? VDI-Technologiezentrum, 1998). Sowohl für TMR Bausteine als auch für die Spintransistoren wäre ein Metall oder Halbmetall mit hoher Spinpolarisation ein großer Vorteil. Den Magnet-Halbleiter-Hybrid-Strukturen liegt die Idee zugrunde, dass man mit magnetischen Schichten für die Spins der Ladungsträger eine Polarisator-Analysator-Anordnung ähnlich wie in der Optik realisieren kann. Je nach relativer Magnetisierungsrichtung der beiden Elektroden würde der Widerstand des Hybrids variieren. Dazu ist erforderlich, dass man erstens spinpolarisierte Ströme durch Injektion über die Halbleiterschicht realisiert und zweitens dass die Spinpolarisation des Stroms über eine ausreichend große Distanz bis zum Analysator erhalten bleibt. Letzteres wurde bereits gezeigt, jedoch wurde von metallischen nichtoxidischen Materialien mit hoher Spinpolarisation (größer als 70 %) bei Raumtemperatur noch nicht berichtet.

Die Bedeutung dieser magnetoresistiven Materialien für magnetische Sensoren und die magnetische Datenspeicherung ist in den letzten Jahren immens gewachsen und besitzt bereits eine hohe kommerzielle Bedeutung. Geeignete Materialien für Produkte mit GMR-Effekt beinhalten nahezu ausschließlich Materialien mit 3-d-Metallen (d.h. Metalle mit teilweise gefüllten 3d-Orbitalen), da diese Metalle die gewünschten magnetischen Eigenschaften zeigen und mit der Prozesstechnik in der Siliziumtechnologie weitgehend kompatibel sind. Ihre prinzipiellen Kennwerte, wie zum Beispiel die Größe des magnetoresistiven Effektes, maximale Einsatztemperatur (Betriebstemperatur der Magnetsensoren), Feldempfindlichkeit usw. sind in den letzten Jahren verbessert worden, ohne dass für alle Einsatzgebiete eine optimale Lösung gefunden wurde.

Der oben angesprochene GMR-Effekt existiert in Mehrfachschichtsystemen. Diese Schichtsysteme bestehen im einfachsten Fall aus zwei magnetischen Schichten, z. B. Eisen, die von einer nichtmagnetischen Zwischenschicht, z. B. Chrom, unterbrochen sind. Der seit 1987 bekannte GMR-Effekt ist vermutlich ein extrinsischer Grenzflächeneffekt (mehrphasiges System) (DE-A 38 20 475). Immer wenn die beiden Eisenschichten über die Chromschicht ferromagnetisch koppeln, ist der Widerstand klein, da die Elektronen ohne Veränderung des Spins in die zweite Eisenschicht übergehen können. Im Falle einer antiferromagnetischen Kopplung zwischen den Spins der beiden Eisenschichten ist der Widerstand dagegen groß. Unter Ferromagnetismus wird im allgemeinen ein kollektiver Magnetismus definiert, bei dem sich die Elektronenspins unterhalb der kritischen Temperatur (Curie-Temperatur) parallel ausrichten. Antiferromagnetismus ist als kollektiver Magnetismus, bei dem sich die Elektronenspins unterhalb der kritischen Temperatur (Neél-Temperatur) antiparallel ausrichten, definiert. Der Widerstand eines Schichtsystems mit antiparalleler Kopplung zwischen den Eisenschichten lässt sich durch ein von außen angelegtes Magnetfeld signifikant reduzieren. Das äußere Magnetfeld erzwingt eine ferromagnetische Ausrichtung der Spins der beiden Eisenschichten in Richtung des Feldes. Maximal 10 % $MR_0$-Effekt können bei Raumtemperatur durch diesen Effekt erreicht werden. Der GMR-Effekt ist heute schon in der technischen Anwendung, insbesondere als Magnetsensor in Leseköpfen für Festplattenlaufwerke (IBM, Mainz).

Der Magnetwiderstand ist eine Größe, die die prozentuale Änderung des Widerstandes eines Systems mit und ohne äußeres Magnetfeld beschreibt. Ein negativer Magnetwiderstand wird als Reduzierung des elektrischen Widerstandes bei externem Magnetfeld, relativ zum Widerstand ohne Magnetfeld, definiert. Im allgemeinen werden zwei verschiedene Definitionen für den prozentualen Magnetwiderstand verwendet. Die in der vorliegenden Erfindung verwendete Definition des prozentualen Magnetwiderstandes $MR_0$ ergibt sich aus der Differenz des Widerstandes ohne Feld und des Widerstandes mit Feld, dividiert durch den Widerstand ohne Feld. Der maximale Wert beträgt 100 %. Eine alternative Definition (z. B. DE-A 38 20 475) wird im Falle des sogenannten GMR (Giant Magnetoresistance)-Effekts verwendet. In diesem Fall ergibt sich der prozentuale Magnetwiderstand $MR_p$ aus der Differenz des Widerstandes ohne Feld und des Widerstandes mit Feld dividiert durch den Widerstand mit Feld. Der maximale Wert kann beliebig groß werden.

Der oben angesprochene TMR-Effekt basiert auf einer nichtleitenden Zwischenschicht zwischen zwei magnetischen Schichten. Ist diese Zwischenschicht dünn genug, dann können Elektronen die Tunnelbarriere überwinden und es kann ein Strom fließen. Auch die Tunnelwahrscheinlichkeit ist spinabhängig, welches zu hohen Werten beim Magnetwiderstand bei paralleler vs. antiparalleler Magnetisierung der Spins in den magnetischen Tunnelkontaktschichten führt. Materialien mit vollständig spinpolarisierten Elektronen würden einen größeren Effekt aufweisen. Die Tunnelwahrscheinlichkeit ist spinabhängig, der Magnetwiderstand bei vollständiger Polarisation der Spins P aufgrund der Beziehung

$$MR = \frac{P}{1-P^2} \text{ maximal.}$$

Die oben angesprochenen Magnetwiderstände (MR) wurden nur in Elementen oder Elementschichten gemessen.

1993 wurden große Magnetwiderstände auch in Verbindungen entdeckt. Der "kolossale Magnetwiderstand" (CMR-Effekt) in den Manganoxiden sorgte für weltweit großes Interesse (R. von Helmold, J. Wecker, B. Holzapfel, L. Schultz, K. Samwer, Phys. Rev. Lett. 71 (1993) Seite 2331), da die Widerstandsänderung bei Anlegen eines äußeren Magnetfeldes wesentlich größer als in den oben beschriebenen Schichtsystemen aus Elementen ist. Der CMR-Effekt ist ein intrinsischer Effekt (Effekt innerhalb einer Verbindung) und die extrem große Änderung des Widerstandes beruht auf der Unterdrückung eines Metall-Isolator-Übergangs bei der Curietemperatur $T_C$. Als Curie-Temperatur ist die kritische Temperatur definiert, unterhalb der sich eine spontane Magnetisierung mit einer parallelen Anordnung der Spinmomente auf benachbarten Atomen, auch als ferromagnetische Anordnung bezeichnet, einstellt. Oberhalb von $T_C$ sind die Spins ungeordnet und die Verbindungen, die einen CMR-Effekt zeigen, sind Isolatoren (Halbleiter), unterhalb von $T_C$ sind diese Verbindungen ferromagnetische Metalle. Der CMR-Effekt wurde zuerst an gemischtvalenten Mangan-Oxiden, z.B. $La_{1-x}Sr_xMnO_3$, gemessen. Der negative MR beim CMR ist durch die Reduktion der Spinunordnung zu erklären. Die Leitfähigkeit ist das "hopping" (hüpfen) von eg-Elektronen zwischen $Mn^{3+}$ und $Mn^{4+}$-Plätzen und dieses "hopping" tritt nur auf, wenn die magnetischen Momente der zwei Mn-Atome parallel ausgerichtet sind, wie im ferromagnetischen Fall. Es findet ein Metall-Isolator-Übergang an der Curietemperatur statt. Bei angelegtem Feld, bei Zunahme des Grades an ferromagnetischer Ordnung, nimmt die Wahrscheinlichkeit des "hoppings" zu und der Widerstand wird erniedrigt. Der Effekt ist daher meistens bei der Curietemperatur am größten. Auch bei dem CMR-Effekt wird eine technologische Anwendung vermutet, jedoch wird der größte Effekt meistens bei Temperaturen unterhalb von Raumtemperatur (nicht im Bereich der Betriebstemperatur von Leseköpfen) gefunden. Auch ist die Feldempfindlichkeit immer noch zu gering und ein epitaktisches Aufwachsen der Verbindungen auf Silizium-Wafern schwierig.

Verbindungen mit CMR-Effekt und $CrO_2$ zeigen in polykristallinen Proben oder kompakten gepreßten Pillen einen sogenannten PMR-Effekt (Powder Magnetoresistance Effect: A. Gupta and J. Z. Sun: Spin-polarized transport and magnetoresistance in magnetic oxides, J. Magn. Magn. Mat. 200 (1999) Seite 24-43). Weit unterhalb der Curie-Temperatur weisen diese Verbindungen eine hohe Polarisation der Elektronen an der Fermi-Energie auf. Dies führt dazu, dass in Proben, die Korngrenzen aufweisen, ein hoher Magnetwiderstand bei kleinen Feldern (bis zu 20 % bei 4 K und 0.1 T) auftritt. Die vollständig spinpolarisierten Elektronen können nur teilweise in Zustände benachbarter Körner mit anders ausgerichteten Elektronen tunneln. Eine isolierende Oxidschicht bildet dabei wahrscheinlich die Tunnelbarriere. Der gemessene Widerstand ist daher groß. Ein äußeres Magnetfeld richtet alle Spins aus und senkt den Widerstand ab, da nun die Leitungselektronen in das benachbarte Korn tunneln können. Alle bisher bekannten Verbindungen weisen jedoch keinen nennenswerten Effekt bei Raumtemperatur auf. Da außerdem alle Verbindungen Oxide sind, ist eine Umsetzung dieser Bausteine zu einem Wafer schwierig. Der größte Effekt bei Raumtemperatur wurde in $Sr_2FeMoO_6$

(6 % bei 1 T, K.-I Kobayashi, Nature 395 677 (1998)) gemessen. Komposite aus einem metallischen Material mit hoher Spinpolarisation und einem isolierenden oder zumindest halbleitendem Material - z.B. Oxide wie $Al_2O_3$, MgO oder $Cr_2O_3$, Fluoride wie $MgF_2$ und andere isolierende oder halbleitende Verbindungen wie Poly- oder Oligomere wie Polystyrol, Polyethylen, Epoxidharze etc. - sollten sich aufgrund des PMR-Effekts als Materialien für die Magnetoelektronik eignen. Das isolierende Material verhindert einen Kurzschluß der metallischen Partikel und dient wahrscheinlich auch als Tunnelbarriere.

Aufgabe der vorliegenden Erfindung war es, Materialien zur Verfügung zu stellen, mit denen sich noch höhere Aufzeichnungsdichten auf Festplattenvorrichtungen (bis zu 8 Gbit/$cm^2$) realisieren lassen, als mit den zur Zeit verwendeten Festplattenvorrichtungen, die auf einem GMR- oder dem TMR-Effekt basieren und eine Aufzeichnungsdichte von etwa 1 Gbit/$cm^2$ ermöglichen. Außerdem sollten die Materialien eine hohe Spinpolarisation bei Raumtemperatur aufweisen, um einen Einsatz als TMR-Element sowie in der Spinelektronik zu ermöglichen. Zur Verwendung als Magnetsensoren in der Automobilindustrie sind hohe Magnetwiderstände bei Temperaturen höher als Raumtemperatur notwendig.

Es bestand demnach ein Bedürfnis nach Materialien, die in Kombination die folgenden Eigenschaften in sich vereinigen:

- die günstigen Kennwerte der Mehrfachschichtsysteme, die einen GMR-Effekt zeigen, nämlich:

  • hohe Feldempfindlichkeit,
  • großer Effekt bei der Betriebstemperatur der Leseköpfe
  • Stabilität des Effektes über einen weiten Temperaturbereich, und

- die günstigen Kennwerte der Verbindungen, die einen CMR-Effekt zeigen, nämlich:

  • extrem großer Effekt in einem Bulk-Material oder einem Komposit aus einem isolierendem Material und einem metallischen Material mit hoher Spinpolarisation, wobei der Effekt nicht empfindlich von der Zwischenschichtdicke wie beim GMR-Effekt abhängt
  • für Spinelektronik: hohe Spinpolarisation möglichst nahe Raumtemperatur.

Die vorliegende Erfindung stellt nun Verbindungen zur Verfügung, die die günstigen Eigenschaften des GMR- und des CMR-Effektes miteinander kombinieren und eine hohe Spinpolarisation bei Raumtemperatur aufweisen; sie erreichen bei besserer Feldempfindlichkeit (verglichen mit den Manganoxiden) einen um Faktor ca. 3 höheren Magnetwiderstand (verglichen mit den GMR- und TMR-Systemen). Während Sensoren in einer Festplattenvorrichtung, die auf einem GMR- oder dem TMR-Effekt basieren etwa 1Gbit/$cm^2$ Aufzeichnungsdichte ermöglichen, sollten mit den erfindungsgemäßen Verbindungen entsprechend höhere Aufzeichnungsdichten (bis zu 10 Gbit($cm^2$) erreicht werden. Im Komposit (granulares Material aus der erfindungsgemäßen Verbindung und einem isolierenden oder zumindest halbleitendem Material) wurden Magnetwiderstandseffekte Effekte bis zu 80 % (80 % bezogen auf dem Widerstand ohne Feld bzw. 700 % bezogen auf die Sättigungsmagnetisierung) gemessen.

Der Erfindung lagen folgende theoretischen Überlegungen zu Grunde: Eine intermetallische Verbindung mit 3d-Metallen als Komponenten könnte die o.g. Anforderungen erfüllen, da solch eine Verbindung die gewünschten Eigenschaften des metallischen Mehrfachschichtsystems und die der Verbindungen, die einen Metall-Isolator-Übergang zeigen, gleichzeitig aufweisen könnte. Zweckmäßigerweise sollte weiterhin die Curietemperatur oberhalb Raumtemperatur (23 °C) liegen, damit der größte Effekt für die Betriebstemperatur der Leseköpfe erreicht wird. Eine Curietemperatur >300°C wäre für spinpolarisiertem Tunneln und für den PMR-Effekt bei Raumtemperatur günstig. Die erfindungsgemäßen Verbindungen zeigen den Effekt über den untersuchten Temperaturbereich bis 400 K nahezu temperaturunabhängig.

Für die Synthese von Verbindungen mit o.g. Anforderungsprofil ist ein Verständnis des theoretischen Modells, das die physikalische Ursache des CMR-Effektes beschreibt, hilfreich. Es lässt sich postulieren, ob eine Verbindung ein Isolator (gerade Anzahl von Valenzelektronen) oder ein Metall (ungerade Anzahl von Valenzelektronen) ist. Sind bestimmte 3d- oder 4f-Metalle Komponenten einer Verbindung, so lässt sich aus dem Abstand dieser Atome im Festkörper eine Aussage über den Magnetismus machen. Diese Einschätzungen sind möglich, da eine Beziehung zwischen der Kristallstruktur einer solchen Verbindung und der Valenzelektronenkonzentration auf der einen Seite und den elektronischen und magnetischen Eigenschaften auf der anderen Seite existiert.

Die Valenzelektronenkonzentration wird als Zahl der Valenzelektronen pro Atom in der Formeleinheit definiert. Unter den Valenzelektronen werden die Elektronen in den Orbitalen eines Elementes verstanden, die nach der letzten (voll besetzten) Edelgasschale aufgefüllt werden. Bei den Übergangsmetallen sind das s-, p- und d-Elektronen, bei den Lanthaniden auch die f-Elektronen.

Die elektronische Struktur eines Festkörpers lässt sich durch die Bandstruktur beschreiben und kann heute mit ausreichender Genauigkeit berechnet werden. Die Bandstruktur ist das Festkörperanalogon der Energieniveaus von Molekülen. Mit spektroskopischen Methoden (wie z. B. Photoemission) kann man die elektronische Struktur von Festkörpern messen.

Das systematische Studium der elektronischen Struktur von bekannten Verbindungen mit den oben genannten elektronischen und magnetischen Eigenschaften ermöglichte es erstmals mittels eines "Fingerabdruckes" ein erstes Rezept zur Synthese von Verbindungen mit Riesenmagnetwiderständen zu formulieren (C. Felser, R. Seshadri, A. Leist, W. Tremel J. Mater. Chem. 8 (1998) Seite 787, C. Felser and R. Seshadri, J. Inorg. Mater. 2 (Raveau Festschrift, 2000) Seite 677).

Auch der GMR-Effekt im oben erwähnten System Fe/Cr/Fe lässt sich aus der elektronischen Struktur des Chroms, der Spindichtewelle (Erläuterung s. u.) und dem Magnetismus des Eisens erklären (P. Bruno, C. Chappert, Phys. Rev. B 46 (1992), Seite 261).

Zur Erklärung des Riesenmagnetwiderstands in den Manganoxiden, dem CMR-Effekt, wird meist der sogenannte Doppelaustausch-Mechanismus (Double Zener Exchange) herangezogen (C. Zener, Phys. Rev. 82 (1951) Seite 403). Dieser Erklärungsansatz ist jedoch auf die gemischtvalenten Manganoxide beschränkt, eine allgemeine Theorie existiert nicht.

Spindichtewellen, die wesentlich für den GMR-Effekt sind, wurden auch als wahrscheinliche Ursache für die Hochtemperatursupraleitung diskutiert (G. Burdett, Chemical Bonding in Solids, Oxford University Press, 1995). Die supraleitenden Cuprate und die Manganoxide mit CMR-Effekt sind aber strukturell verwandt. Spindichtewellen als Mitursache für Riesenmagnetwiderstände wurden schon 1998 vermutet (C. Felser, R. Seshadri, A. Leist, W. Tremel J. Mater. Chem. 8 (1998) Seite 787). Spindichtewellen sind Folgen der besonderen elektronischen Struktur der Manganoxide. Aus den Bandstrukturrechnungen, den Berechnungen der elektronischen Struktur der Verbindungen, läßt sich erkennen, ob eine Verbindung eine Spindichtewelle zeigt. Zur Darstellung der elektronischen Struktur eines dreidimensionalen Festkörpers benötigt man theoretisch ein vierdimensionales Diagramm, die drei Raumrichtungen (im Impulsraum) und die Energie. Eine dreidimensionale Darstellungsmöglichkeit ist die Energie-Isofläche, eine Fläche (im Impulsraum) mit konstanter Energie. Die Energie-Isofläche, die besetzte von unbesetzten Zuständen trennt, ist die sogenannte Fermi-Fläche, die zugehörige Energie die Fermi-Energie. In dieser Darstellung der elektronischen Struktur sind Spindichtewellen als parallele Flächen in der Energie-Isofläche erkennbar. Aufgrund der Symmetrie der Kristallstruktur und der Valenzelektronenkonzentration weisen die Manganoxide solch einen "Fingerabdruck" in der elektronischen Struktur auf. Das magnetische Manganoxid, welches einen CMR-Effekt zeigt, weist ein zusätzliches lokales magnetisches Moment auf. Unter einem lokalen magnetischen Moment versteht man Verbindungen mit ungepaarten Elektronen, paramagnetische Verbindungen, die unterhalb der kritischen Temperatur $T_C$ magnetisch ordnen. Die Ursache für das lokale magnetische Moment in den Manganaten ist eine nur teilweise gefüllte Elektronenschale, in diesem Fall die halbbesetzten $t_{2g}$-Orbitale des Mangans.

Auch im Fall der Verbindungen kann es, je nach Wellenlänge der Spindichtewelle (welche sich aus der Bandstruktur ergibt) relativ zum Abstand der magnetischen Atome im Festkörper, zur Ausbildung einer antiferromagnetischen Ordnung kommen. Dieser "Fingerabdruck" (=Spindichtewellen) wurde bei Supraleitern und magnetischen Systemen mit negativem Riesenmagnetwiderstand gefunden. Die Erkenntnisse aus der elektronischen Struktur von den supraleitenden Verbindungen und die konsequente Anwendung des Modells haben zur Vorhersage und zur anschließenden experimentellen Verifizierung eines CMR-Effekts in $GdI_2$ geführt (C. Felser, R. Seshadri, J. Mater. Chem. 9 (1999) Seite 459, C. Felser, K. Thieme, R. Seshadri, J. Mater. Chem. 9 (1999) Seite 459, C. Felser, K. Ahn, R. K. Kremer, R. Seshadri and A. Simon, J. Solid. State Chem. 147, (1999) Seite 19). $GdI_2$ ordnet ferromagnetisch bei 290 K und zeigt einen CMR-Effekt mit einem Magnetwiderstand $MR_0$ von 70 % bei Raumtemperatur und 7 T. Auch wenn diese Verbindung bis zur Synthese der erfindungsgemäßen Verbindung Weltrekordhalter bei Raumtemperatur war, so ist wegen der chemischen Reaktivität der Verbindung (die Verbindung reagiert mit $H_2$, $H_2O$ und $O_2$) und der geringen Feldempfindlichkeit eine technische Anwendung nicht möglich.

Mittlerweile ist ein neues wesentlich erweitertes Modell entwickelt worden. Neben der oben angesprochenen Spindichtewelle ist ein Sattelpunkt in der Bandstruktur für CMR-Verbindungen vorteilhaft. Ein Sattelpunkt (entsprechend der mathematischen Definition) in der spinpolarisierten Bandstruktur führt zu einer hohen Zustandsdichte. Unter der Zustandsdichte versteht man die Summe der Energieniveaus in einem bestimmten Energieintervall. Eine hohe Zustandsdichte (mehr als 3 Zustände pro Elementarzelle und eV) an der Fermi-Energie, der Energie, die die besetzten von den unbesetzten Zuständen trennt, ist für das elektronische System ungünstig und wird daher als elektronische Instabilität bezeichnet. Das Vorhandensein dieser beiden Instabilitäten (Spindichtewelle und Sattelpunkt) an der Fermi-Energie ist für die Grundzustandseigenschaften von Verbindungen mit außergewöhnlichen elektronischen und magnetischen Eigenschaften günstig.

Der Fingerabdruck für Verbindungen mit Riesenmagnetwiderstand besteht demnach aus drei Teilen: Sattelpunkt, Spindichtewelle und lokales magnetisches Moment. Der Sattelpunkt führt scheinbar zu einer ferromagnetischen Kopplung zwischen den magnetischen Atomen (siehe Hedin, J. Magn. Mat. 177 (1998) Seite 599), während die Spindichtewelle zu einer antiferromagnetischen Anordnung der Spins benachbarter Atome führt. Diese Konkurrenz zwischen ferromagnetischer und antiferromagnetischer Kopplung ist offenbar die Ursache für die starke Änderung des Widerstandes bei der Curietemperatur und damit für den Riesenmagnetwiderstand in Verbindungen verantwortlich.

Weisen die Materialien darüber hinaus noch eine hohe Spinpolarisation an der Fermi-Energie auf, so sind die Magnetwiderstands-Effekte besonders groß. Unter der Spinpolarisation bei einer bestimmten Energie versteht man das Verhältnis der Zustandsdichten in den beiden Spinrichtungen. Ist die Spinpolarisation maximal so beträgt ihr Wert 1 (eine unmagnetische Verbindung hat den Wert 0) und der Magnetwiderstand der beim PMR und beim TMR-Effekt von der Spinpolarisation abhängt wäre wegen $MR = \dfrac{P}{1-P^2}$ auch maximal.

Weiterhin haben sich neben dem oben beschriebenen dreiteiligen Fingerabdruck (Sattelpunkt, Spindichtewelle und lokales magnetisches Moment) noch weitere zweckmäßige Forderungen ergeben. Instabilitäten finden sich häufiger in der Bandstruktur von Festkörpern, allerdings beeinflussen sie die elektronischen Eigenschaften nur, wenn sie sich wirklich in der Nähe der Fermi-Energie befinden. Eine Verschiebung der Fermi-Energie kann zwar theoretisch durch Dotierung einer Verbindung mit Elektronen oder Löchern erreicht werden, ist praktisch aber oft schwierig. Die Fermi-Energie lässt sich durch Dotierung mit Elektronen zu höheren Energien durch Dotierung mit Löchern zu niedrigeren Energien verschieben. Dadurch erreicht man, dass sich die Instabilität in der Bandstruktur genau an der Fermi-Energie befindet. Will man eine Verbindung wie $SrMnO_3$ mit Elektronen dotieren, so ersetzt man den entsprechenden Teil Strontiumatome durch Lanthanatome. Als Kandidaten kommen daher nur Verbindungssysteme in Frage, die sich dotieren lassen, d. h. die für verschiedene Elementkombinationen und für verschiedene Valenzelektronenkonzentrationen existieren und in denen sich einzelne Atome durch andere Atome ersetzen lassen.

Intermetallische Verbindungen wie die Heusler-Verbindungen erfüllen genau die geforderten Voraussetzungen:

- Dreiteiliger Fingerabdruck in der Bandstruktur

  - Sattelpunkt
  - Spindichtewelle
  - Lokales magnetische Moment

- Halbmetallischer Ferromagnet
- variable Valenzelektronenkonzentration
- Hochsymmetrische Strukturen
- Curietemperatur > 500 K

Voraussetzung für die Möglichkeit eines MR-Effektes mit

- hoher Feldempfindlichkeit,
- großer Effekt bei der Betriebstemperatur der Leseköpfe,
- Stabilität des Effektes über einen weiten Temperaturbereich, und
- extrem großer Effekt in einem Bulk-Material oder Kompositmaterial, wobei der Effekt nicht empfindlich von der Zwischenschichtdicke wie beim GMR-Effekt abhängt
- für Spinelektronik: hohe Spinpolarisation möglichst nahe Raumtemperatur.

Heusler-Verbindungen bzw. Semi-Heusler-Verbindungen werden beispielsweise in den folgenden Dokumenten beschrieben: Kaczmarska K. et al: "Anderson localization of 3d Mn states in semi-Heusler phases", Physical Review B, Bd. 60, Nr. 1, Seiten 373-382; US-A-6 069 820; sowie Ishida S., Fuji S., Kashiwagi S., Asano S.: "Search for half-metallic compounds in Co2MnZ (Z=IIIb, Vb element)", Journal of the Physical Society of Japan, Bd. 64, Nr. 6, Juni 1995, Seiten 2152-2157.

Für das Erreichen einer hohen Feldempfindlichkeit der Verbindungen mit Riesenmagnetwiderständen sind intermetallische Verbindungen zweckmäßig und insbesondere unter den Heusler-Phasen sind halbmetallische Ferromagnete zu finden. Heusler-Phasen sind intermetallische Verbindungen der allgemeinen Zusammensetzung $X_2YZ$ und kristallisieren in der $BiF_3$-Typ-Struktur (Pearson=s Handbook of Crystallographic Data for Intermetallic Phases, ASM International, The Materials Information Society, 1991). Unter intermetallischen Verbindungen werden Verbindungen
a) zwischen zwei oder mehreren echten Metallen ($T_1$ und $T_2$)
b) zwischen einem oder mehreren echten Metallen und einem oder mehreren echten Metallen der B-Untergruppe
c) zwischen zwei oder mehreren Metallen der B-Untergruppe verstanden, wobei die Eigenschaften beim Übergang von der 1. zur 3. Klasse weniger metallisch werden und zunehmend ähnlicher echten chemischen Verbindungen werden. Die Klassifizierung in echte Metalle und Elemente der B-Untergruppen wurde an Tabelle 13.1 aus R.C. Evans (Einführung in die Kristallchemie, Walter de Gruyter Verlag Berlin New York 1976 S. 276) angelehnt:

| Echte Metalle | | | | | | | | | | | | Elemente der B-Untergruppen | | | | |
|---|---|---|---|---|---|---|---|---|---|---|---|---|---|---|---|---|
| $T_1$ | | $T_2$ | | | | | | | | | | $B_1$ | | $B_2$ | | |
| Li | Be | | | | | | | | | | | | | | | |
| Na | Mg | | | | | | | | | | | | Al | Si | | S |
| K | Ca | Sc | Ti | V | Cr | Mn | Fe | Co | Ni | Cu | Zn | Ga | Ge | As | Se |
| Rb | Sr | Y | Zr | Nb | Mo | Tc | Ru | Rh | Pd | Ag | Cd | In | Sn | Sb | Te |
| Cs | Ba | La | Hf | Ta | W | Re | Os | Ir | Pt | Au | Hg | Tl | Pb | Bi | Po |

Die Metalle der Lanthan- und Actinumreihe gehören zur Klasse $T_2$.

Die kubische Struktur des $BiF_3$-Typs zeichnet sich durch vier penetrierende fcc-Gitter aus. X und Y sind meist Übergangsmetallelemente ($T_2$ in Tabelle oben), manchmal ist Y auch ein Seltenerd-Element. Z ist ein nichtmagnetisches Metall oder ein Nichtmetall ($B_1$ oder $B_2$). Heusler-Phasen haben wegen ihres magnetischen Verhaltens, dem magnetooptischen Kerreffekt, technologische Bedeutung erlangt. Die magnetischen Eigenschaften der meisten bekannten Heusler-Phasen sind daher relativ gut untersucht, insbesondere sind die ferromagnetische Curie-Temperatur und das magnetische Moment bekannt. Die elektronischen Eigenschaften, wie die Leitfähigkeit, sind dagegen im allgemeinen selten untersucht worden. Bis auf das kürzlich entdeckte halbleitende, nichtmagnetische $Fe_2VAl$, sind alle bisher bekannten Heusler-Verbindungen (d.s. mehrere hundert verschiedene Phasen) Metalle; einige ferromagnetische Heusler-Verbindungen zeichnen sich von ihrer Bandstruktur als halbmetallische Ferromagnete aus. Auch die hohe Symmetrie der kubischen Struktur erwies sich wegen des Auftretens von elektronischen Instabilitäten als günstig. Heusler-Phasen existieren über einen relativ großen Valenzelektronenkonzentrationsbereich, so dass auch die Dotierung der Verbindungen mit Elektronen oder Löchern je nach Bedarf, unproblematisch sein sollte. Da die magnetischen Verbindungen relativ gut untersucht sind, lässt sich aus der ferromagnetischen Curie-Temperatur der bekannten Verbindungen auf die Curie Temperatur der unbekannten neuen oder dotierten Verbindung schließen. Die Bandstrukturrechnungen an verschiedenen Heusler-Verbindungen zeigten, dass diese Verbindungsklasse entweder die oben aufgeführten Kriterien direkt oder bei geeigneter Einstellung der Valenzelektronenkonzentration durch Variation der Elemente erfüllte. Für eine Valenzelektronenkonzentration von 6.95 ± 0.5, vorzugsweise ± 0.2, insbesondere ± 0.1, ganz besonders bevorzugt ± 0.02 Valenzelektronen pro Atom in der Formeleinheit befanden sich die Instabilitäten (Sattelpunkt und Spindichtewelle) an der Fermi-Energie. Weitere Instabilitäten in nicht erfindungsgemäßen Heusler-Verbindungen treten für Valenzelektronenkonzentrationen von 5.5 ± 0.5, vorzugsweise ± 0.2, insbesondere ± 0.1, ganz besonders bevorzugt ± 0.02 Valenzelektronen pro Formeleinheit und 7.13 ± 0.5, vorzugsweise ± 0.2, insbesondere ± 0.1, ganz besonders bevorzugt ± 0.02 Valenzelektronen pro Formeleinheit auf.

Da bekannte Heusler-Verbindungen eine solche Valenzelektronenkonzentration insbesondere unter Einschluss aller Zusatzbedingungen (z. B. Curietemperatur im Bereich der Betriebstemperatur der Leseköpfe) nicht aufweisen, war eine Dotierung der bekannten Verbindung notwendig. Dabei wurde angenommen, dass sich die Bandstruktur durch die Dotierung nicht verändert und nur die Fermi-Energie verschoben wird (die sogenannte rigid-band-model-Annahme). In der Tat zeigten die dann unter Anwendung der obigen Theorie synthetisierten Heusler-Verbindungen $Co_2Cr_{0.6}Fe_{0.4}Al$ (VEK=6.95), $Co_2Cr_{0.6}Fe_{0.4}Ga$ (VEK=6.95) und $Co_2Cr_{0.2}Mn_{0.8}Al$ (VEK=6.95) den erwarteten Riesenmagnetwiderstand. Die durchgeführten elektronischen Untersuchungen zeigten, dass die erfindungsgemäßen Verbindungen $Co_2Cr_{0.6}Fe_{0.4}Al$, $Co_2Cr_{0.2}Mn_{0.8}Al$ und $Co_2Cr_{0.6}Fe_{0.4}Ga$, wie postuliert, die günstigen Eigenschaften des GMR- (große Feldempfindlichkeit) und des CMR-Effektes (großer Effekt in einer Verbindung) vereinten. Die erfindungsgemäßen Heusler-Phasen weisen einen Magnetwiderstand größenordnungsmäßig vergleichbar mit den Manganiten (dem sogenannten CMR (colossal magnetoresistance)-Effekt) und eine Feldempfindlichkeit so empfindlich wie in den Vielfachschichtsystem (den sogenannten giant magnetoresistance: GMR-Effekt) auf. Da der Effekt in polykristallinen Proben gemessen wurde, kann auf eine fast 100 % Spinpolarisation geschlossen werden. Weitere ähnliche Verbindungen sind beispielsweise $Co_2Mn_{0.8}Cr_{0.2}Al$, $Co_2Mn_{0.8}Cr_{0.2}Ga$ (VEK=6.95) sowie $Co_2MnGe_{0.5}Ga_{0.5}$, $Co_2MnSi_{0.5}Al_{0.5}$, $Co_2MnSn_{0.5}In_{0.5}$, $Co_2Mn_{0.5}Cr_{0.5}Si$, $Co_2Mn_{0.5}Fe_{0.5}Al$, $Co_2Mn_{0.5}Fe_{0.5}Ga$, $Co_2Mn_{0.5}Fe_{0.5}In$, $Fe_2CoGe_{0.5}Ga_{0.5}$, $Fe_{2.5}Co_{0.5}Ga$ (VEK=7.13).

Die erfindungsgemäßen Verbindungen weisen einen negativen Magnetwiderstand mit einer intrinsischen Feldempfindlichkeit von >10 % pro 0.1 T, vorzugsweise >20 % pro 0.1 T, besonders bevorzugt >70 % pro 0.1 T bei Raumtemperatur auf. Beimischung von Oxiden führt zu einer Erhöhung der PMR-Effektes. Die erfindungsgemäßen Verbindungen sind intermetallische Verbindungen, die kubische Symmetrie mit vorzugsweise keiner, gegebenenfalls geringer struktureller Verzerrung aufweisen. Unter struktureller Verzerrung wird eine Abweichung der Gitterparameter von <10 %, insbesondere <5 %, vorzugsweise <2 % verstanden. Die erfindungsgemäßen Verbindungen gehören den Heusler-Phasen an. Die erfindungsgemäßen Verbindungen weisen zweckmäßigerweise elektronische Instabilitäten (Sattelpunkt, Spindichtewelle und lokales magnetisches Moment) in der Nähe der Fermi-Energie auf. Unter ,in der Nähe der Fermi-Energie= wird eine Differenz zwischen Instabilität und Fermi-Energie von höchsten " 0.5 eV, bevorzugt " 0.2 eV, insbesondere " 0.1 eV, ganz besonders bevorzugt $\pm$ 0.02 Valenzelektronen pro Formeleinheit und 7.13 $\pm$ 0.5, vorzugsweise $\pm$0.2, insbesondere $\pm$ 0.1, ganz besonders bevorzugt $\pm$ 0.02 Valenzelektronen pro Formeleinheit zu finden. Im Fall einer konkreten Verbindungen kann die optimierte Valenzelektronenkonzentration durch eine genaue Bandstrukturrechnung eben für diese Verbindung bestimmt werden. Optimale Eigenschaften wurden bisher in den Verbindungen $Co_2Cr_{0.6}Fe_{0.4}Al$, $Co_2Cr_{0.6}Fe_{0.4}Ga$ und $Co_2Cr_{0.2}Mn_{0.8}Al$ berechnet und auch gefunden. Berechnungsbeispiel: Das Element Co hat 9 Valenzelektronen, Cr hat 6, Fe hat 8 und Al hat 3 Valenzelektronen, bei einer stöchiometrischen Zusammensetzung von $Co_2Cr_{0.6}Fe_{0.4}Al$ ergeben sich mit 2x9+0.6x6+0.4x8+3=27.8 Valenzelektronen pro Formeleinheit und nach Division durch 4: 6.95 Valenzelektronen pro Atom. Sie weisen ein lokales magnetisches Moment mit einer Curietemperatur größer als Raumtemperatur (RT = 23°C) auf. Die erfindungsgemäßen Verbindungen $Co_2Cr_{0.6}Fe_{0.4}Al$, $Co_2Cr_{0.2}Mn_{0.8}Al$ und $Co_2Cr_{0.6}Fe_{0.4}Ga$ sind halbmetallische Ferromagnete, weshalb der gemessenen Effekt besonders groß ist. Erfindungsgemäße Komposite, die einen PMR-Effekt von >10 % pro 0.1 T, insbesondere von >20 % pro 0.1 T, vorzugsweise >50 % pro 0.1 T, besonders bevorzugt >80 % pro 0.1 T bei Raumtemperatur aufweisen, sind granulare Materialien aus erfindungsgemäßen Verbindungen und einem isolierenden Material wie z.B. $Al_2O_3$ in Beimischungen von beispielsweise 15 $\pm$15 Mol%, vorzugsweise $\pm$10 Mol%, insbesondere $\pm$5 Mol%, ganz besonders bevorzugt $\pm$2 Mol%. Hierbei wurden Magnetwiderstandseffekte Effekte bis zu 80 % (80 % bezogen auf dem Widerstand ohne Feld bzw. 700 % bezogen auf die Sättigungsmagnetisierung) gemessen. Der Effekt ist über einen weiten Temperaturbereich >50°C, insbesondere von >100°C, vorzugsweise >200°C besonders bevorzugt >400°C stabil d.h. der Effekt schwankt in diesem Temperaturbereich um weniger als 50%, insbesondere weniger als 20%, besonders bevorzugt weniger als 10%. Diese Material kann sowohl als "Bulkmaterial", eingebettet in andere Materialien wie Epoxidharze oder Polymere, direkt als Magnetsensor in der Magnetoelektronik verwendet werden als auch als granularer Film.

Die erfindungsgemäßen Verbindungen zeigen als Bulkmaterial oder als Komposit

- einen hohen negativen Magnetwiderstand $MR_0$ (>10 %, bevorzugt >20 %, insbesondere bevorzugt >80 % (80 % bezogen auf dem Widerstand ohne Feld bzw. 700 % bezogen auf die Sättigungsmagnetisierung) und damit signifikant größer als die GMR-Systeme);

    - bei Temperaturen höher als Raumtemperatur (vorzugsweise bei der üblichen Betriebstemperatur von Leseköpfen, ca. 25 bis 55 °C);

- einen großen Magnetwiderstandseffekt auch über einen weiten Temperaturbereich (>100°, bevorzugt >200°, insbesondere bevorzugt >400°);
- eine hohe Feldempfindlichkeit (>10 % pro 0.1 Tesla, bevorzugt >20 % pro 0.1 Tesla, insbesondere bevorzugt >70 % pro 0.1 Tesla);
- einen PMR-Effekt bei Raumtemperatur (>5 % pro 0.1 Tesla, bevorzugt >20 % pro 0.1 Tesla, insbesondere bevorzugt >50 % pro 0.1 Tesla);
- eine hohe thermische Zersetzungsstabilität (bis 50°C, bevorzugt bis 80°C, insbesondere bevorzugt bis 100°C) und chemische Stabilität (resistent gegen $H_2O$, $O_2$, besonders bevorzugt auch gegen Alkalien und Säuren);
- Kompatibilität mit der Prozesstechnik in der Siliziumtechnologie;
- eine hohe Spinpolarisation (>60 %, bevorzugt >70 % und besonders bevorzugt >90 %) an der Fermi-Energie für eine breite Anwendung in der Magnetoelektronik.

Die erfindungsgemäßen Verbindungen lassen sich aus zwei oder mehreren verschiedenen Elementen herstellen, wobei die Elemente nach Art und Menge so ausgewählt sind, dass die resultierende Verbindung kubisch mit einer maximalen Verzerrung der Gitterparameter von 10 %, vorzugsweise $\leq$5 %, insbesondere $\leq$2 %, kristallisiert. Die kubische Symmetrie wird in erster Näherung von den Radienverhältnissen der Atome bestimmt (R.C. Evans Einführung in die Kristallchemie, Walter de Gruyter Verlag Berlin New York 1976 S. 276). Idealerweise wählt man die Elemente und die Stöchiometrie in der Weise aus, dass die resultierende Verbindung zu den Heusler-Phasen zählt. Die ausgewählten Elemente werden in der entsprechenden Stöchiometrie eingewogen und beispielsweise in einer Inertgasatmosphäre mit einem Lichtbogenschweißgerät aufgeschmolzen. Die resultierende Verbindung sollte eine elektronische Instabilität (Sattelpunkt, Spindichtewelle) in der Nähe (d. h. $\pm$0.5, bevorzugt $\pm$0.2, besonders bevorzugt $\pm$0.1 eV) der Fermi-Energie aufweisen. Ist dies nicht der Fall, sollte die Verbindung zweckmäßigerweise entsprechend der theoretisch berechneten elektronischen Struktur mit Elektronen oder Löchern dotiert werden. Bevorzugt werden die Elementkombinationen aus denen eine Verbindung resultiert, die eine Valenzelektronenkonzentration von 6.95 $\pm$ 0.5, bevorzugt 6.95 $\pm$ 0.2, insbesondere 6.95 $\pm$ 0.1, ganz besonders bevorzugt $\pm$0.02 aufweisen. Alternative nicht erfindungsgemäße Valenzelektronenkonzentrationen sind 5.5 $\pm$ 0.5, vorzugsweise $\pm$ 0.2, insbesondere $\pm$ 0.1, ganz besonders bevorzugt $\pm$ 0.02 Valenzelektronen pro Formeleinheit und 7.13 $\pm$ 0.5, vorzugsweise $\pm$ 0.2, insbesondere $\pm$ 0.1, ganz besonders bevorzugt $\pm$

0.02 Valenzelektronen pro Formeleinheit. Zweckmäßig wäre es, wenn die resultierende Verbindung ein lokales magnetisches Moment und eine Curietemperatur oberhalb von Raumtemperatur aufweist. Aus den synthetisierten Verbindungen wählt man die aus, die halbmetallische Ferromagnete sind, das sind die Verbindungen mit Zustandsdichte für nur eine Spinrichtung an der Fermi-Energie.

Im Folgenden wird die Erfindung anhand von Beispielen näher erläutert.

Beispiele

Die Verbindungen wurden entsprechend dem stöchiometrischen Verhältnis aus den Elementen synthetisiert. Aus dem eingewogenen Gemenge werden Pillen gepresst und diese für ca. 30 Sekunden in einer Inertgasatmosphäre mit einem Lichtbogenschweißgerät aufgeschmolzen. Zweckmäßigerweise wird dieser Prozess zur Homogenisierung der Proben mehrmals wiederholt. Der Gewichtsverlust beträgt in der Regel weniger als 5 Gew.-%. Es hat sich als zweckmäßig erwiesen, die Proben nicht über längere Zeit bei hohen Temperaturen zu tempern. Proben, die 5 Tage bei 800 °C in Quarzampullen im Vakuum getempert wurden, zeigten einen kleineren Effekt, aber kein verändertes Röntgenpulverdiagramm. Um die magnetoresistiven Eigenschaften zu untersuchen, wurden Leitfähigkeitsmessungen mit und ohne externem magnetischen Feld durchgeführt. Die Leitfähigkeitsmessungen erfolgten an Proben mittels der 4-Punkt-Meßtechnik in einem Helium-Badkryostaten der Firma Oxford von 300 K bis 4 K. R(T)-Kurven wurden im Nullfeld und mit einem Magnetfeld von 8 Tesla aufgenommen. Die B-Feld-Abhängigkeit der Leitfähigkeit wurde außerdem bei ausgewählten Temperaturen mit angelegten Magnetfeldern von -8 bis +8 Tesla durchgeführt. Die Schmelzkugel der entsprechenden Verbindung wurde für die Untersuchung des Leitfähigkeitsverhaltens gemörsert und Pillen mit einem Durchmesser von 8 mm und einer Dicke von etwa 1 mm mit einer Last von 5 Tonnen gepresst.

Beispiel 1: $Co_2Cr_{0.6}Fe_{0.4}Al$

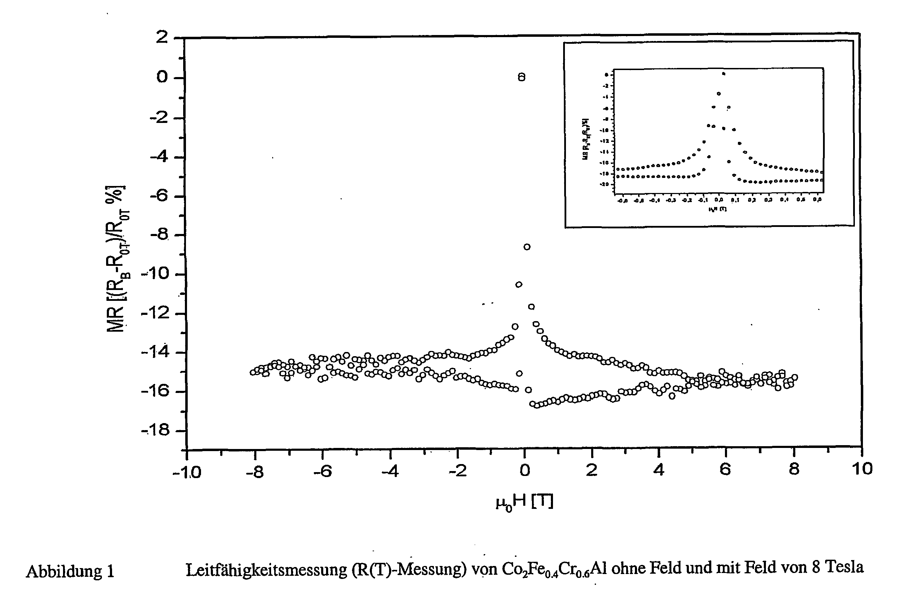

Die Verbindung wurde entsprechend dem stöchiometrischen Verhältnis aus den Elementen (Co, 99.8%, Fa. Alfa, Karlsruhe; Cr, 99.8 %, Fa. Alfa, Karlsruhe; Al, 99.99%, Fa. Chempur, Karlsruhe; Fe, 99.9%, Fa. Alfa, Karlsruhe) mit einer Gesamteinwaage von 2 g synthetisiert. Aus dem eingewogenen Gemenge wurden Pillen gepresst und für ca. 30 Sekunden in einer 700-mbar-Argonatmosphäre mit einem Lichtbogenschweißgerät aufgeschmolzen (Strom 65 A, Spannung 20 V). Dieser Prozeß wurde zur Homogenisierung der Proben dreimal wiederholt. Der Gewichtsverlust betrug weniger als 2 %. Die Reinheit des Produkts wurde mit einem Transmissionsröntgenpulverdiffraktometer (Siemens, D5000) mit $Cu-K_\alpha$-Strahlung überprüft. Die Phase $Co_2Cr_{0.6}Fe_{0.4}Al$ zeigte keine Verunreinigungen (Heusler-Phase mit $Co_2CrAl$-Struktur; kubisch, a= 0.5724 nm). In Abbildung 1 ist die R(T)-Kurve bei 0 Tesla gezeigt. Die elektrische Widerstandskurve ohne äußeres Magnetfeld zeigt ein breites lokales Maximum bei 300K. Der elektrische Widerstand nimmt zu tieferen Temperaturen bis etwa 150K ab. Danach steigt der elektrische Widerstand wieder an, was auf ein aktiviertes Verhalten deutet.

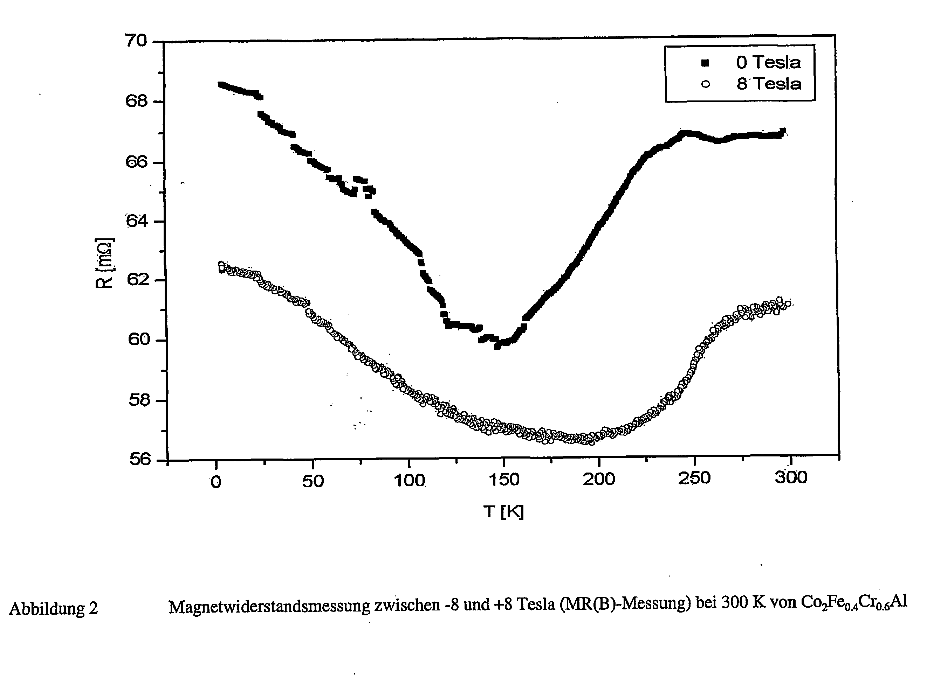

Durch das Anlegen eines äußeren Magnetfeldes von 8 Tesla wird der Widerstand insgesamt abgesenkt. Dabei wird der scharfe Übergang bei 150 K unterdrückt, was zu einer Glättung und Verschiebung des lokalen Minimums zu höheren Temperaturen führt (Abbildung 1). Die Messung der Feldabhängigkeit des Magnetowiderstandes bei 4 K zeigt bei Feldern von 2 T einen negativen Magnetowiderstand von annähernd 10 %. Mit steigender Temperatur steigt dieser Wert auf 12 % bei 200 K und auf annähernd 20 % bei 300 K (Abbildung 2). Messungen zwischen -0.1 bis +0.1 T zeigten eine außergewöhnlich hohe Feldempfindlichkeit dieser Verbindungen. Eine Sättigung mit einem Effekt von mehr als 20 % wurde bei einem Feld von 0.1 T, von 10 % bei etwa 0.03 T erreicht.

Beispiel 2: $Co_2Cr_{0.6}Fe_{0.4}Al$ + 10 Mol-% $Al_2O_3$

Die Verbindung $Co_2Cr_{0.6}Fe_{0.4}Al$ wurde wie in Beispiel 1 beschrieben hergestellt. Das Produkt wurde fein gemörsert und mit 15 Molprozent $Al_2O_3$ (99.9%, Fa. Chempur) homogenisiert. Danach wurde das Gemisch zu einer Pille gepresst.

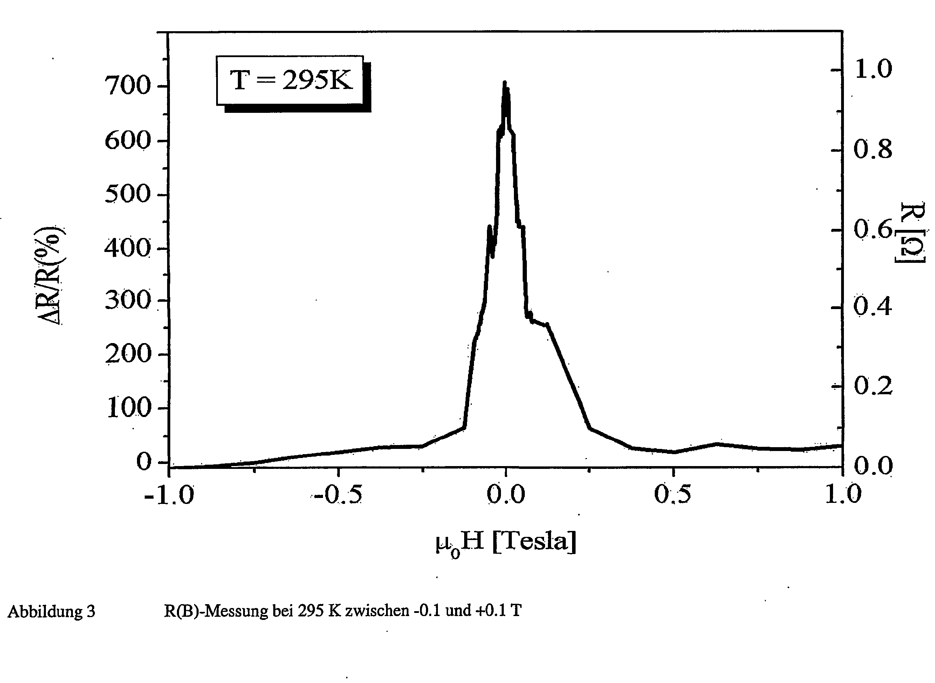

In Abbildung 3 ist die R(B)-Messung von dieser Probe bei 295 K gezeigt. Die Beobachtung der Feldabhängigkeit des Magnetowiderstandes bei 295 K zeigt bei Feldern von 0.1 T einen negativen Magnetowiderstand von annähernd 700 % bezogen auf die Sättigungsmagnetisierung. Messungen zwischen -0.1 bis +0.1 T zeigten eine außergewöhnlich hohe Feldempfindlichkeit dieser Verbindungen. Eine Sättigung mit einen Effekt von mehr als 40 % wurde bei einem Feld von 0.05 T gemessen.

**Patentansprüche**

1. Anorganische intermetallische Verbindung mit PMR-Effekt, **dadurch gekennzeichnet, dass** sie eine intrinsische Feldempfindlichkeit von >10% pro 0.1 T bei Temperaturen höher als 290 K aufweist, wobei die Verbindung $Co_2Cr_{0.6}Fe_{0.4}Al$, $Co_2Cr_{0.6}Fe_{0.4}Ga$ oder $Co_2Cr_{0.2}Mn_{0.8}Al$ ist und eine kubische Symmetrie aufweist, mit einer maximalen Abweichung der Gitterparameter von 10 %.

2. Komposit aus mindestens einer Verbindung gemäß Anspruch 1 und mindestens einer isolierenden oder halbleitenden Substanz.

3. Komposit nach Anspruch 2, **dadurch gekennzeichnet, dass** die isolierende oder halbleitende Substanz in einer Menge von $\geq$ 15 Mol-% (bezogen auf die eingesetzte Verbindung) eingesetzt wird.

4. Komposit nach Anspruch 2 oder 3, **dadurch gekennzeichnet, dass** die isolierende oder halbleitende Verbindung ausgewählt wird aus einer oder mehreren der folgenden Substanzen: Oxiden, Fluoriden, Polymeren und Oligomeren.

5. Komposit nach einem der Ansprüche 2 bis 4, **dadurch gekennzeichnet, dass** es einen PMR-Effekt mit einer Feldempfindlichkeit von >10 % pro 0.1 T bei Temperaturen höher als 290 K aufweist.

6. Komposit nach einem der Ansprüche 2 bis 5, **dadurch gekennzeichnet, dass** der PMR-Effekt bei Temperaturen $\geq$Raumtemperatur (23°C) auftritt.

7. Verwendung einer Verbindung nach Anspruch 1 oder eines Komposits nach einem der Ansprüche 2-6 zur Herstellung von Leseköpfen in Speichermedien.

8. Verwendung einer Verbindung nach Anspruch 1 oder eines Komposits nach einem der Ansprüche 2-6 als Magnetfeldsensoren.

9. Verwendung einer Verbindung nach Anspruch 1 oder eines Komposits nach einem der Ansprüche 2-6 in der Spinelektronik.

10. Verwendung einer Verbindung nach Anspruch 1 oder eines Komposits nach einem der Ansprüche 2-6 zur Herstellung von TMR-Devices.

**Claims**

1. An inorganic intermetallic compound with a PMR effect, **characterised in that** it features intrinsic field sensitivity > 10 % per 0.1 T at temperatures greater than 290 K, whereby the compound is $CO_2Cr_{0.6}Fe_{0.4}Al$, $CO_2Cr_{0.6}Fe_{0.4}$-Ga or $CO_2Cr_{0.2}Mn_{0.8}Al$ and features cubical symmetry, with a maximum deviation of 10 % from the lattice parameter.

2. A composite of at least one compound in accordance with claim 1 and at least of an insulating or a semi-conducting substance.

3. The composite according to claim 2, **characterised in that** the insulating or semi-conducting substance in applied to an amount $\geq$ 15 Mol-% (based on the applied compound).

4. The composite according to claim 2 or 3, **characterised in that** the insulating or semi-conducting compound is selected from one or several of the following substances: oxides, fluorides, polymers, and oligomers.

5. The composite according to one of claims 2 to 4, **characterised in that** it features a PMR effect with field sensitivity > 10 % per 0.1 T at temperatures greater than 290 K.

6. The composite according to one of claims 2 to 5, **characterised in that** the PMR effect occurs at temperatures $\geq$ ambient temperature (23 °C).

7. An application of a compound according to claim 1 or of a composite according to one of claims 2 - 6 for the manufacture of reading heads in data recording media.

8. The application of a compound according to claim 1 or of a composite according to one of claims 2 - 6 for magnetic field sensors.

**9.** The application of a compound according to claim 1 or of a composite according to one of claims 2 - 6 used in spin electronics.

**10.** The application of a compound according to claim 1 or of a composite according to one of claims 2 - 6 for the manufacture of TMR devices.

**Revendications**

**1.** Composé inorganique intermétallique avec effet PMR (magnétorésistance de poudre), **caractérisé en ce qu'**il présente une sensibilité de champ intrinsèque > 10 % par 0,1 T à des températures supérieures à 290 K, le composé étant $Co_2Cr_{0,6}Fe_{0,4}AL$, $Co_2Cr_{0,6}Fe_{0,4}Ga$ ou $Co_2Cr_{0,2}Mn_{0,8}Al$ et présentant une symétrie cubique, avec un écart maximal du paramètre cristallin de 10 %.

**2.** Composite à base d'au moins un composé selon la revendication 1 et au moins une substance isolante ou semi-conductrice.

**3.** Composite selon la revendication 2 **caractérisé en ce que** la substance isolante ou semi-conductrice est employée à une quantité de ≥ 15 % en moles (par rapport au composé employé).

**4.** Composite selon les revendications 2 ou 3 **caractérisé en ce que** le composé isolant ou semi-conducteur est choisi parmi l'une ou plusieurs des substances suivantes : oxydes, fluorures, polymères et oligomères.

**5.** Composite selon l'une des revendications de 2 à 4 **caractérisé en ce qu'**il présente un effet PMR avec une sensibilité de champ ≥ 10 % par 0,1 T pour des températures supérieures à 290 K.

**6.** Composite selon l'une des revendications de 2 à 5 **caractérisé en ce que** l'effet PMR apparaît à des températures ≥ à la température ambiante (23 °C).

**7.** Utilisation d'un composé selon la revendication 1 ou d'un composite selon l'une des revendications de 2 à 6 pour la fabrication de têtes de lecture dans des supports de données.

**8.** Utilisation d'un composé selon la revendication 1 ou d'un composite selon l'une des revendications de 2 à 6 en tant que capteurs de champ magnétique.

**9.** Utilisation d'un composé selon la revendication 1 ou d'un composite selon l'une des revendications de 2 à 6 dans l'électronique de spin.

**10.** Utilisation d'un composé selon la revendication 1 ou d'un composite selon l'une des revendications de 2 à 6 pour la fabrication d'unités TMR (magnéto-résistifs à effet tunnel)

Leitfähigkeitsmessung (R(T)-Messung) von $Co_2Fe_{0.4}Cr_{0.6}Al$ ohne Feld und mit Feld von 8 Tesla

Abbildung 1

Abbildung 2 — Magnetwiderstandsmessung zwischen -8 und +8 Tesla (MR(B)-Messung) bei 300 K von $Co_2Fe_{0.4}Cr_{0.6}Al$

Abbildung 3          R(B)-Messung bei 295 K zwischen -0.1 und +0.1 T

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3820475 A
- US 6069820 A

**In der Beschreibung aufgeführte Nicht-Patentliteratur**

- **S. MENGEL.** Innovationspotential Magnetoelektronik. *Physikalische Blätter,* 1999, vol. 55 (5), 53-56
- **G. BAYREUTHER ; S. MENGEL.** Magnetoelektronik, Grundlagenforschung - Zukunftstechnologie?. *VDI-Technologiezentrum,* 1998
- **A. GUPTA ; J. Z. SUN.** Spin-polarized transport and magnetoresistance in magnetic oxides. *J. Magn. Magn. Mat.,* 1999, vol. 200, 24-43
- **T, K.-I KOBAYASHI.** *Nature,* 1998, 395-677
- **C. FELSER ; R. SESHADRI, A. ; LEIST, W. ; TREMEL J.** *Mater. Chem.,* 1998, vol. 8, 787
- **C. FELSER ; R. SESHADRI.** *Inorg. Mater.,* 2000, 677
- **P. BRUNO ; C. CHAPPERT.** *Phys. Rev. B,* 1992, vol. 46, 261
- **C. ZENER.** *Phys. Rev.,* 1951, vol. 82, 403
- **G. BURDETT.** Chemical Bonding in Solids. Oxford University Press, 1995
- **C. FELSER ; R. SESHADRI.** *J. Mater. Chem.,* 1999, vol. 9, 459
- **C. FELSER ; K. THIEME ; R. SESHADRI.** *J. Mater. Chem.,* 1999, vol. 9, 459
- **C. FELSER ; K. AHN ; R. K. KREMER ; R. SESHADRI ; A. SIMON.** *J. Solid. State Chem.,* 1999, vol. 147, 19
- **HEDIN.** *J. Magn. Mat.,* 1998, vol. 177, 599
- **KACZMARSKA K. et al.** Anderson localization of 3d Mn states in semi-Heusler phases. *Physical Review B,* vol. 60 (1), 373-382
- **ISHIDA S. ; FUJI S. ; KASHIWAGI S. ; ASANO S.** Search for half-metallic compounds in Co2MnZ (Z=IIb, Vb element. *Journal of the Physical Society of Japan,* Juni 1995, vol. 64 (6), 2152-2157
- Pearson=s Handbook of Crystallographic Data for Intermetallic Phases. ASM International, 1991
- **R.C. EVANS.** Einführung in die Kristallchemie. Walter de Gruyter Verlag, 1976, 276